# EUROPÄISCHE PATENTSCHRIFT

(11) **EP 1 103 630 B1**
(45) Veröffentlichungstag und Bekanntmachung des Hinweises auf die Patenterteilung: **17.12.2003**
(21) Anmeldenummer: 00124558.8
(22) Anmeldetag: 09.11.2000
(51) Int. Cl.: C23C 14/32, H01J 37/32

(54) **Elektrodenanordnung**
Electrode assembly
Ensemble électrode

(30) Priorität: 17.11.1999 DE 19955373; 19.05.2000 DE 10024827
(43) Veröffentlichungstag der Anmeldung: 30.05.2001
(73) Patentinhaber: Applied Films GmbH & Co. KG, 63755 Alzenau (DE)
(72) Erfinder: Gebele, Thomas, 63579 Freigericht (DE); Bangert, Stefan, 36396 Steinau (DE); Budke, Elisabeth, Dr., 50354 Hürth (DE); Grimm, Helmut, Dr., 64291 Darmstadt (DE); Henrich, Jürgen, 63694 Limeshain (DE); Honekamp, Jürgen, 63457 Hanau (DE); Ulrich, Jürgen, 61137 Schöneck (DE)
(74) Vertreter: Herrmann-Trentepohl, Werner, Dipl.-Ing.

(56) Entgegenhaltungen:
- WO-A-00/46418
- DE-A- 4 026 494

## Beschreibung

Die Erfindung betrifft eine Elektrodenanordnung zur plasmaunterstützten Beschichtung eines Substrats.

Eine solche Elektrodenanordnung wird beispielsweise eingesetzt, um auf einer Substratoberfläche eine oder mehrere Materialschichten abzuscheiden, so dass das Substrat über die Oberfläche bestimmte physikalische Eigenschaften bereitstellt. Anwendungen sind beispielsweise die Beschichtung einer Glasscheibe mit einer optisch wirksamen Schicht, so dass die Glasscheibe gewünschte Reflexions- bzw. Transmissionseigenschaften aufweist, oder die Beschichtung einer Kunststofffolie mit einer Materialschicht, so dass die Kunststofffolie als Diffusionssperre wirksam ist.

Aus PCT/EP 99/00768 ist eine Elektrodenanordnung zur Beschichtung eines Substrats mit einer Materialschicht bekannt, welche zwei Materialkomponenten umfasst, wobei die zweite Materialkomponente als Dotierung zu einem geringeren Anteil in der Materialschicht enthalten ist als die erste Materialkomponente. Die erste Materialkomponente wird in einem Tiegel zur Verdampfung bereitgestellt, während die zweite Materialkomponente an der Oberfläche einer bezüglich des Tiegels als Kathode geschalteten Elektrode bereitgestellt wird. Zwischen der Kathode und dem entsprechend als Anode wirkenden Tiegel bildet sich aufgrund einer geeignet gewählten Potentialdifferenz und des Drucks und der Zusammensetzung eines zwischen Anode und Kathode vorhandenen Gases eine Bogenentladung aus. Aufgrund der Bogenentladung lösen sich Partikel der zweiten Materialkomponente von der Kathodenoberfläche, mischen sich und reagieren mit den von der Anode abgedampften Partikeln der ersten Materialkomponente, so dass sich auf einer in der Nähe der Kathode und der Anode angeordneten Substratoberfläche eine Materialschicht abscheidet, die die beiden Materialkomponenten enthält. Die Anteile der beiden Materialkomponenten in der abgeschiedenen Materialschicht können eingestellt werden, indem die Stärke der Verdampfung aus dem Tiegel und die Stärke der Bogenentladung in gewissem Rahmen unabhängig voneinander einstellbar sind.

Die Stärke und Effizienz der Bogenentladung wird hierbei durch die Oberflächeneigenschaften der Kathode beeinflusst. Bei der herkömmlichen Elektrodenanordnung besteht ein Problem darin, dass von der Anode abgedampfte Partikel der ersten Materialkomponente bzw. Reaktionsprodukte hiervon sich auf der Oberfläche der die zweite Materialkomponente bereitstellenden Kathode abscheiden. Hierdurch werden die Oberflächeneigenschaften der Kathode während des Betriebs der Elektrodenanordnung verändert, was zu zeitlichen Änderungen der Intensität und Effizienz der Bogenentladung führt und damit die Abscheidung von Materialschichten mit definierter Zusammensetzung auf dem Substrat erschwert. Insbesondere können Abscheidungen der ersten Materialkomponente auf der Kathode dazu führen, dass die Bogenentladung erlischt und ein weiterer Betrieb der Elektrodenanordnung mit der verunreinigten Kathode unmöglich ist. Es ist dann ein Austausch der Kathode notwendig, welcher im Hinblick auf die Fertigungseffizienz der Materialschicht nachteilig ist.

Zwar ist aus der DE 40 26 494 Al eine Vorrichtung zur Materialverdampfung mittels Vakuum-Lichtbogen-Entladung mit selbstverzehrender kalter Kathode und heißer verdampfenden Anode bekannt, bei der eine Verunreinigung der Beschichtung aus Anodenmaterial mit Kathodenmaterial durch entsprechende Abschirmungsmaßnahmen vermieden wird, allerdings unterscheidet sich diese Vorrichtung von der gattungsgemäßen Vorrichtung der vorliegenden Erfindung dadurch, dass das Kathodenmaterial grundsätzlich nicht als Beschichtungsmaterial verwendet werden soll.

Es ist Aufgabe der vorliegenden Erfindung, eine Elektrodenanordnung der eingangs geschilderten Art bereitzustellen, welche eine kontinuierlichere Beschichtung eines Substrats mit einer gewünschten Materialzusammensetzung erlaubt.

Die Erfindung geht dabei aus von einer Elektrodenanordnung zur plasmaunterstützten Beschichtung eines Substrats mit einer Materialschicht, welche wenigstens eine erste und eine zweite Materialkomponente umfasst. Zur Erzeugung einer Plasmaentladung sind hierbei eine Anodenanordnung und eine Kathodenanordnung vorgesehen, wobei die Anodenanordnung die erste Materialkomponente an einer Anodenmaterialoberfläche zur Verdampfung bereitstellt, und die Kathodenanordnung die zweite Materialkomponente entsprechend an einer Kathodenmaterialoberfläche bereitstellt.
Die Erfindung zeichnet sich dadurch aus, dass die Kathodenmaterialoberfläche in zwei Bereiche unterteilt ist, nämlich einen die Plasmaentladung stützenden verdampfungsaktiven Teil und einen die Plasmaentladung nicht stützenden verdampfungsinaktiven Teil, wobei eine Blendenanordnung vorgesehen ist, deren Blendenöffnung den verdampfungsaktiven Teil für die Plasmaentladung exponiert und welche den verdampfungsaktiven Teil der Kathodenmaterialoberfläche gegenüber der Plasmaentladung abschattet. Bei einer gegebenen Grösse der Kathodenmaterialoberfläche und einer gegebenen Stärke der Plasmaentladung ist somit im Vergleich zu einer nicht in zwei Bereiche unterteilten Kathodenmaterial-Oberfläche die Intensität der Plasmaentladung pro Flächeneinheit im Bereich des verdampfungsaktiven Teils erhöht.

Vorzugweise ist hierbei eine Bewegungserzeugungseinrichtung vorgesehen, welche die Anordnung des verdampfungsaktiven Teils auf der Kathodenmaterialoberfläche zeitlich ändert und den verdampfungsaktiven Teil somit über die Kathodenmaterialoberfläche bewegt. Hierdurch stützen zeitlich ständig sich ändernde Bereiche der Kathodenmaterialoberfläche die Plasmaentladung.

In Zusammenhang mit der Bewegungserzeugungseinrichtung oder alternativ hierzu ist eine Schutzgaszuführung auf die Kathodenoberfläche zweckmässig, wobei das Schutzgas so geführt wird, dass es in Richtung der abgedampften Partikel von der aktiven Kathodenoberfläche in dem Prozessraum austritt und verhindert, dass abgedampfte Materialkomponenten von der Anodenmaterialoberfläche auf die Kathoden gelangen und sich dort als isolierende Sichicht niederschlagen. Als Gas wird hierbei inertes Schutzgas vorzugsweise verwendet. Hierbei genügt die Zuführung von Schutzgas auf den verdampfungsaktiven Teil der Kathodenoberfläche dergestalt, dass das Schutzgas in Richtung der Plasmaentladung in den Prozessraum austritt, jedoch ist es zweckmässig, die Schutzgasführung so zu legen, dass die gesamte Kathode von Schutzgas umspült wird.

Der Erfindung liegt die Erkenntnis zugrunde, dass eine intensive Plasmaentladung eine reinigende Wirkung auf die Kathodenmaterialoberfläche aufweist. Somit können während des Betriebs entstehende Abscheidungen der ersten Materialkomponente auf der Kathodenoberfläche durch die intensive Plasmaentladung ständig wieder entfernt werden, um eine zeitlich konstante Plasmaentladung zu erzielen.

Bei einem gewünschten Anteil der zweiten Materialkomponente in der abgeschiedenen Materialschicht ist der Intensität der Plasmaentladung allerdings eine Grenze gesetzt, da sich sonst der Anteil der zweiten Materialkomponente in der Materialschicht zu stark erhöhen würde. Diese somit vorgegebene Intensität der Plasmaentladung könnte dann aber zu gering sein, um Abscheidungen der ersten Materialkomponente auf der Kathodenmaterialoberfläche zu entfernen.

Durch die erfindungsgemäße Unterteilung der Kathodenmaterialoberfläche in einen verdampfungsaktiven Teil und einen verdampfungsinaktiven Teil ist es durch geeignete Wahl des Flächenanteils des verdampfungsaktiven Teils an der Gesamtfläche der Kathodenmaterialoberfläche allerdings möglich, in dem verdampfungsaktiven Teil der Kathodenmaterialoberfläche die Plasmaentladung derart intensiv auszubilden, dass dort die Abscheidungen der ersten Materialkomponente im wesentlichen entfernt werden. Es wird somit die Kathodenmaterialoberfläche durch die Bogenentladung lokal gereinigt, und die Bewegung des verdampfungsaktiven Teils über die Kathodenmaterialoberfläche führt schließlich zu einer Reinigung im wesentlichen der gesamten Kathodenmaterialoberfläche, so dass die Kathode insgesamt zeitlich im wesentlichen konstante oder im Vergleich zur herkömmlichen Elektrodenanordnung sich weniger ändernde Oberflächeneigenschaften aufweist und insbesondere ein Zusammenbruch der Bogenentladung aufgrund der Abscheidungen der ersten Materialkomponente auf der Kathodenmaterialoberfläche weitgehend vermeidbar ist.

Hierbei ist selbstverständlich der Übergang zwischen dem verdampfungsaktiven Teil zum verdampfungsinaktiven Teil der Kathodenmaterialoberflächen nicht notwendigerweise mikroskopisch scharf, so daß die beiden Teile je nach Auslegung der Elektrodengeometrie in einem mehr oder weniger breiten Übergangsbereich ineinander übergehen können.

Die Bewegung des verdampfungsaktiven Teils über die Kathodenmaterialoberfläche erfolgt vorzugsweise dadurch, dass bei der Blendenanordnung, deren Blendenöffnung den verdampfungsaktiven Teil für die Plasmaentladung exponiert und welche den verdampfungsinaktiven Teil der Kathodenmaterialoberfläche gegenüber der Plasmaentladung abschattet, ein Antrieb vorgesehen ist, um die Blendenöffnung relativ zu der Kathodenmaterialoberfläche zu bewegen. Bezüglich der Anodenanordnung ist die Blendenöffnung hierbei vorzugsweise feststehend angeordnet.

Gemäss einer bevorzugten Ausgestaltung ist die Kathodenmaterialoberfläche hierbei als Zylinderaussenmantelfläche ausgebildet, welche durch den Antrieb um die Zylinderachse drehantreibbar ist.

Alternativ hierzu und ebenfalls bevorzugt ist eine Ausgestaltung, bei der die Kathodenmaterialoberfläche als Kreisringfläche ausgebildet ist, welche durch den Antrieb um eine senkrecht zu der Kreisringfläche sich erstreckende Zentralachse drehantreibbar ist.

Weiterhin ist alternativ hierzu und ebenfalls bevorzugt eine Ausgestaltung der Kathodenmaterialoberfläche als sich linear erstreckende Fläche eines Kathodenmaterialkkörpers vorgesehen, welcher durch den Antrieb in eine Erstreckungsrichtung der Fläche hin- und herbewegbar ist.

Vorzugsweise umgreift die Blendenanordnung die Kathode wenigstens teilweise haubenartig derart, dass zwischen dem den verdampfungsinaktiven Teil gegenüber der Plasmaentladung abschattenden Teil der Blendenanordnung und der Kathodenmaterialoberfläche ein Zwischenraum verbleibt. In diesen Zwischenraum wird dann ein Spülgas extern eingeleitet, welches aus dem Zwischenraum durch die Blendenöffnung entweicht. Hierdurch wird im Bereich der Blendenöffnung und damit im Bereich des verdampfungsaktiven Teils der Kathodenmaterialoberfläche ein Gasstrom erzeugt, der weg von der Kathodenmaterialoberfläche gerichtet ist. Dieser Gasstrom weg von der Oberfläche vermindert die Zahl der auf der Kathodenmaterialoberfläche auftreffenden Partikel der ersten Materialkomponente bzw. Reaktionprodukten hiervon und unterstützt somit den gleichmässigen Betrieb der Elektrodenanordnung.

In Kombination mit der Blendenanordnung ist vorzugsweise die Ausbildung der Kathodenmaterialoberfläche als konvexe Fläche vorgesehen, so dass die Plasmaentladung in einem zu der Anode hinweisenden Bereich der Kathodenmaterialoberfläche stattfindet und dadurch den verdampfungsaktiven Teil definiert. Hierbei ist dann ein Antrieb vorgesehen, der die Orientierung des Kathodenmaterialkörpers bezüglich der Anode ändert, um den verdampfungsaktiven Teil über die Kathodenmaterialoberfläche zu bewegen.

Zur Unterstützung der Reinigungswirkung der Plasmaentladung auf die Kathodenmaterialoberfläche sind vorzugsweise Reinigungsmittel vorgesehen, die im Bereich des verdampfungsinaktiven Teils Materialabscheidungen auf der Kathodenmaterialoberfläche entfernen. Da der verdampfungsinaktive Teil der Kathodenmaterialoberfläche an der Plasmaentladung nicht teilnimmt, ist in diesem Bereich ein Zugang zu der Kathodenmaterialoberfläche einfach möglich, und ggf. auf der Kathodenmaterialoberfläche vorhandene Verunreinigungen können dann dort vergleichsweise einfach entfernt werden.

Die Reinigungsmittel umfassen vorzugsweise eine Abstreifvorrichtung, insbesondere eine Bürste, oder/und eine die Kathodenmaterialoberfläche abrasiv bearbeitende Vorrichtung oder/und eine die Kathodenmaterialoberfläche spanabhebend bearbeitende Vorrichtung. Hierbei ist es auch möglich, dass die Reinigungsmittel nicht nur die Materialabscheidungen, sondern auch Teile des Kathodenmaterialkörpers selbst entfernen, so dass dieser ständig eine reproduzierbare, insbesondere plane, Kathodenmaterialoberfläche bereitstellt.

Um eine möglichst gleichmässige räumliche Verteilung der von der Kathodenmaterialoberfläche ausgehenden Partikel der zweiten Materialkoponente bezüglich der Anode zu erzielen, umfasst die Kathodenanordnung vorzugsweise eine Mehrzahl von mit räumlichem Abstand voneinander angeordneten verdampfungsaktiven Teilen der Kathodenmaterialoberfläche.

Obwohl die aufgrund der Bogenentladung der ersten Materialkomponente zugeführte Energie deren Verdampfung wenigstens teilweise unterstützt, ist vorzugsweise eine Heizeinrichtung für die erste Materialkomponente vorgesehen. Hierdurch ist es möglich, die Anteile der ersten bzw. der zweiten Materialkomponente an der abgeschiedenen Materialschicht unabhängig voneinander einzustellen. Die Heizeinrichtung ist vorzugsweise ein heizbarer Schmelztiegel zur Verflüssigung der ersten Materialkomponente.

Gemäss einer bevorzugten Ausgestaltung umfasst die erste Materialkomponente Silicium und die zweite Materialkomponente Kupfer oder/und Zink oder Messing. Diese Elektrodenanordnung wird dann vorzugsweise eingesetzt zur Beschichtung von Kunststoffen, wie insbesondere Polyethylenterephthalat (PET), insbesondere zur Verwendung als Verpackung für Lebensmittel, mit einer Materialschicht, die eine Diffusionssperre bzw. Permeationssperre bereitstellt. Das Substrat für die Beschichtung kann hierbei eine Verpackungsfolie sein, die als Bandmaterial an der Elektrodenanordnung vorbeigeführt wird, oder es handelt sich vorzugsweise um einen Behälter und weiter bevorzugt um eine Getränkeflaschen aus PET, welche an der Elektrodenanordnung zur Beschichtung vorbeigeführt werden und hierbei weiter bevorzugt rotieren, so dass die Beschichtung gleichförmig über den Umfang der Flasche erfolgt. Vorzugsweise ist hierbei eine Mehrzahl von mit Abstand voneinander und in Reihe oder versetzt zueinander angeordneten Elektrodenanordnungen vorgesehen.

Die Erfindung wird nachfolgend anhand von Zeichnungen erläutert. Hierbei zeigen:
- Fig. 1: eine schematische Darstellung einer ersten Ausführungsform der Erfindung im Querschnitt;
- Fig. 2: einen Schnitt durch eine in Fig. 1 dargestellte Kathodenanodnung entlang der Linie II-II,
- Fig. 3: eine der Fig. 1 entsprechende Darstellung einer zweiten Ausführungsform der Erfindung,
- Fig. 4: eine der Fig. 1 entsprechende Darstellung einer dritten Ausführungsform der Erfindung,
- Fig. 5: eine der Fig. 1 entsprechende Darstellung einer vierten Ausführungsform der Erfindung, und
- Fig. 6 u. 7: Ausführungsformen mit einer feststehenden Elektrodenanordnung.

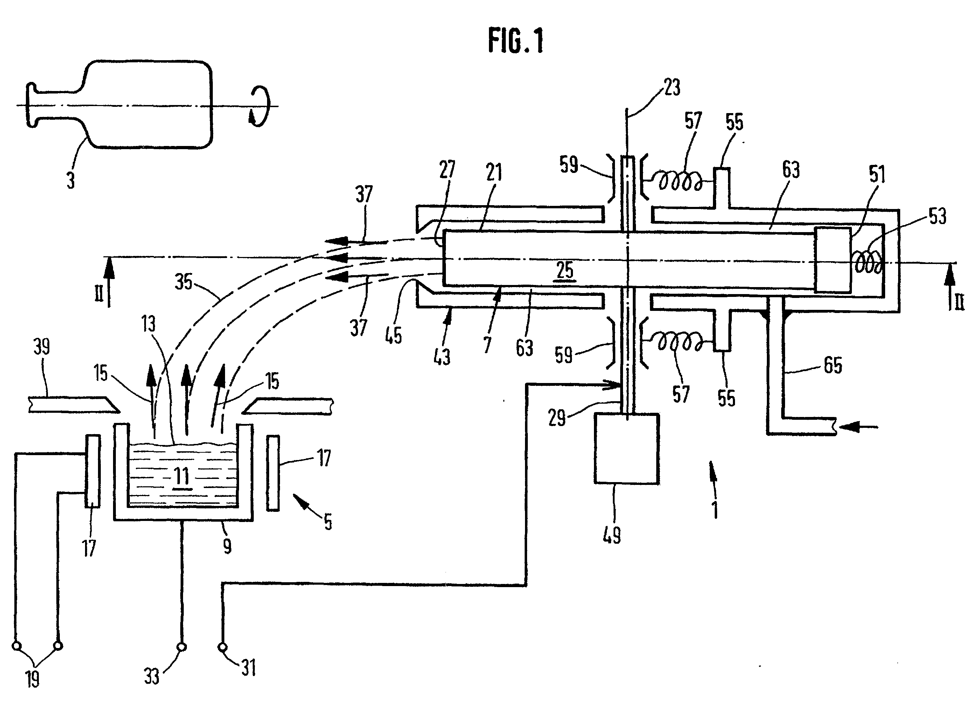

Fig. 1 zeigt eine Elektrodenanordnung 1 zur Beschichtung einer Getränkeflasche 3 aus PET mit einer als Diffusionsbarriere wirkenden Materialschicht aus im wesentlichen SiOₓ, welche mit Metallatomen dotiert ist. Die Beschichtung findet in einer Vakuumatmosphäre bei einem Druck von etwa 2x10⁻⁴ mbar statt. Die Elektrodenanordnung 1 umfasst eine Anodenanordnung 5 und eine Kathodenanordnung 7.

Die Anodenanordnung 5 umfasst einen Tiegel 9, in dem eine Siliciumschmelze 11 aufgenommen ist, von deren Oberfläche 13 Siliciumpartikel in den Gasraum über dem Tiegel 19 und in Richtung hin zu der Getränkeflasche 3 abdampfen. Pfeile 15 symbolisieren hierbei die von der Siliciumoberfläche 13 abdampfenden Partikel.

Der Tiegel 9 ist mittels einer elektrischen Heizeinrichtung 17 geheizt, welcher über Anschlüsse 19 Heizenergie aus einer nicht dargestellten gesteuerten Stromquelle zugeführt wird. Die Anodenanordnung 5 entspricht im wesentlichen der Anordnung, wie sie in PCT/99/00768 beschrieben ist, auf welche hier voll umfänglich Bezug genommen wird.

Die Kathodenanordnung 7 umfasst einen zylindrischen Kathodenkörper 21 aus Messing mit einer Zylinderachse 23 und einer Aussenmantelfläche 25, wobei ein der Siliciumschmelze 11 naheliegender Teil 27 der Zylindermantelfläche 25 orthogonal und schräg versetzt zu der Oberfläche 13 der Siliciumschmelze 11 angeordnet ist. Der Zylinderkörper 21 aus Messing ist über eine fest mit diesem verbundene und entlang der Zylinderachse 23 sich erstreckende Welle 29 mit einer Zuführungsleitung 31 elektrisch kontaktiert.

Ferner ist die Siliciumschmelze 11 über den Tiegel 9 mit einer Zuführungsleitung 33 elektrisch kontaktiert, wobei die Zuführungsleitungen 31 und 33 mit einer weiteren nicht dargestellten gesteuerten Stromquelle derart verbunden sind, dass der Zylinderkörper 21 als Kathode geschaltet ist und die Siliciumschmelze 11 als Anode geschaltet ist. Durch entsprechende Einstellung der Spannung zwischen den Anschlüssen 31 und 33 wird zwischen der Kathodenanordnung 7 und der Anodenanordnung 5 eine Bogenentladung aufrecht erhalten, wobei gestrichelte Linien 35 Bahnen der Bogenfunken andeuten. Die Bogenentladung kann mittels einer oder mehrerer in den Figuren nicht dargestellten Hilfselektroden gezündet werden. Durch die Bogenentladung werden aus dem der Anodenanordnung 5 naheliegenden Teil 27 der Zylinderumfangsfläche 25 Partikel des Zylinderkörpers 21 freigesetzt und bewegen sich in eine Richtung, wie sie durch Pfeile 37 in Fig. 1 angegeben ist, hin in den Gas raum zwischen der Siliciumoberfläche 13 und der zu beschichtenden Getränkeflasche 3. Dort mischen sich die Metallpartikel 37 mit den Siliciumpartikeln 15, wobei dort auch Reaktionen zwischen den Partikeln und mit der vorhandenen Gasatmosphäre stattfinden und schließlich eine Abscheidung der Partikel und deren Reaktionsprodukte auf der Getränkeflasche 3 zur gewünschten Materialschicht stattfindet. Hierbei bilden die von dem Messingzylinder 21 abgedampften Partikel einen im Vergleich zu den von der Siliciumoberfläche 13 abgedampften Materialpartikeln kleinen Anteil der Materialschicht, so dass diese als Dotierung in der SiOₓ Materialschicht betrachtet werden können.

Über dem Tiegel 9 und der Heizeinrichtung 17 ist zu deren Schutz eine Blende 39 vorgesehen, welche bezüglich der Siliciumschmelze 11 und dem Messingzylinder 21 auf schwebendem Potential gehalten ist.

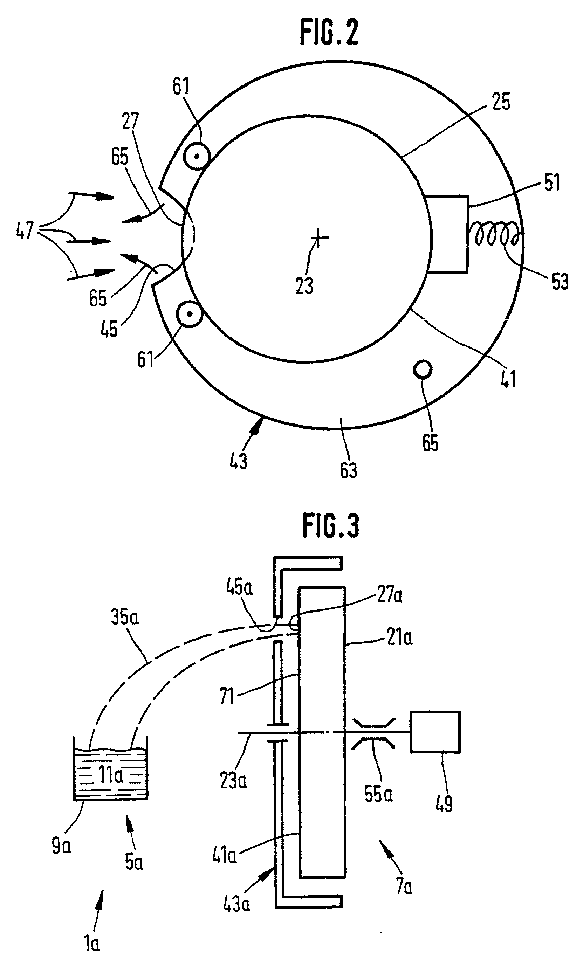

Die Entladungsfunken 35 bilden sich aufgrund der Feldwirkung in dem zu der Anodenanordnung 5 hinweisenden Teil 27 des Zylindermantels 25 aus, so dass dort ein verdampfungsaktiver Teil 27 der Zylindermantelfläche 25 gebildet ist, während der verleibende Teil 41 der Zylindermantelfläche 25 keine Fusspunkte für Funkenentladungen 35 bildet und somit ein verdampfungsinaktiver Teil 41 der Zylindermantelfläche 25 ist. Der verdampfungsaktive Teil 27 wird jedoch nicht nur durch die Feldwirkung auf den der Anodenanordnung 5 zuweisenden Teil der Zylindermantelfläche 25 beschränkt, sondern auch durch die Wirkung einer Blendenanordnung 43, welche den Messingzylinder 21 haubenartig im wesentlichen geschlossen umgreift und in ihrem der Anodenanordnung 5 zuweisenden Bereich eine Blendenöffnung 45 aufweist. Die Blendenanordnung 43 liegt bezüglich der Siliciumschmelze 11 und dem Messingzylinder 21 auf schwebendem Potential, so dass die Blendenanordnung 43 den Messingzylinder 21 in dem verdampfungsinaktiven Teil 41 der Zylindermantelfläche 25 gegenüber Funken 35 abschirmt. Die von der Oberfläche 13 der Siliciumschmelze 11 ausgehenden Partikel 15 erfahren in dem Gasraum zwischen Siliciumschmelze 11 und der Getränkeflasche 3 Streuungen, sowie Reaktionen mit Gaspartikeln, so dass sich ebenfalls Partikel dieser Art auf die Zylindermantelfläche 25 zubewegen, wie dies durch Pfeile 47 in Fig. 2 angedeutet ist. Diese Partikel führen zu Materialabscheidungen, meistens als Siliciumoxid, auf der Zylindermantelfläche 25 und begünstigen damit eine zeitlich ungleichmässige Stärke der Bogenentladung 35.

Durch die Beschränkung des verdampfungsaktiven Teils 27 der Zylindermantelfläche 25 auf lediglich einen Teil der Zylindermantelfläche 25 und die entsprechende Verstärkung der Intensität der Bogenentladung in dem verdampfungsaktiven Teil 27 ist es jedoch möglich, die Intensität der Bogenentladung dort derart hoch auszulegen, dass die Bogenentladung 35 selbst die Zylindermantelfläche 25 von Abscheidungen 47 aus Silicium und dessen Zusammensetzungen soweit reinigt, dass durch die Zylindermantelfläche 25 für die Bogenentladung 35 zeitlich weitgehend konstante Bedingungen bereitgestellt werden können. Um hierbei die gesamte zur Abdampfung vorgesehene Fläche der Zylindermantelfläche 25 von Abscheidungen ständig zu reinigen, ist ein Motor 49 vorgesehen, der die Welle 29 und damit die Zylindermantelfläche 25 bezüglich der Blendenanordnung 43 in Drehung versetzt, so dass nach und nach jeder Bereich der Zylindermantelfläche 25 als verdampfungsaktiver Teil 27 durch die intensive Plasmaentladung 35 behandelt und damit von Abscheidungen 47 gereinigt wird.

Ergänzend zu der Reinigung durch die Bogenentladung 35 wird die Zylindermantelfläche 25 durch einen Schleifklotz 51 gereinigt, welcher im verdampfungsinaktiven Teil 41 mittels einer sich an der Blendenanordnung 43 abstützenden Feder 53 gegen die Zylindermantelfläche 25 gedrückt wird. Bei Rotation des Messingzylinders 21 um die Zylinderachse 23 entfernt der Schleifklotz 51 Materialabscheidungen 47 von der Zylindermantelfläche 25 und hält diese auch weitgehend plan, indem aufgrund der Bogenentladung 35 in dem verdampfungsaktiven Teil 27 erzeugte Unebenheiten verschliffen werden.

An der Blendenanordnung 47 sind Widerlager 55 fest angebracht, welche über Federn 57 Lager 59 der Welle 29 in Richtung zu der Anodenanordnung 5 hin vorspannen. Hierdurch wird der Messingzylinder 21 mit seiner Zylindermantelfläche 25 gegen Rollenlager 61 gedrückt, welche nahe der Blendenöffnung 45 im verdampfungsinaktiven Teil 41 der Zylindermantelfläche 25 angeordnet sind. Hierdurch wird erreicht, daß bei zunehmendem Materialabtrag von dem Messingzylinder 21 aufgrund der Verdampfungswirkung durch die Bogenentladung 35 und des Abschleifens durch den Schleifklotz 51 und damit einhergehende Durchmesserverminderung des Messingzylinders 21 der verdampfunsaktive Teil 27 der Zylindermantelfläche 25 stets in im wesentlichen gleicher räumlicher Beziehung bezüglich der Blendenöffnung 45 und der Anodenanordnung 5 gehalten wird, so dass eine zeitlich gleichförmige Bogenentladung unabhängig von dem Materialabtrag des Messingzylinders 21 aufrechterhalten werden kann.

In einen zwischen dem Zylinderaußenmantel 25 und der Blende 43 gebildeten Zwischenraum 63 wird über eine Leitung 65 ein Gas, z. B. Sauerstoff, eingeführt. Wenigstens ein Teil des über die Leitung 65 zugeführten Gases tritt aus dem Zwischenraum 63 durch die Blendenöffnung 45 in Richtung zu dem Gasraum zwischen Siliciumschmelze 11 und Getränkeflasche 3 aus, wie dies in Fig. 2 durch Pfeile 65 angedeutet ist. Der hierdurch entstehende Gasstrom 65 ist entgegengesetzt zur Bewegungsrichtung 47 der Partikel gerichtet, die zu den ungewünschten Ablagerungen auf der Zylindermantelfläche 25 führen. Hierbei werden Gaspartikel 65 mit dem Strom unerwünschter Partikel 47 kollidieren und diese von ihrem Weg durch die Blendenöffnung 45 und darauffolgender Abscheidung auf der Zylindermantelfläche 25 abbringen, wodurch der unerwünschte Effekt der Materialabscheidung auf der Zylindermantelfläche 25 ebenfalls reduziert wird.

Nachfolgend werden Abwandlungen der in den Fig. 1 und 2 dargestellten Ausführungsform der Erfindung erläutert. Hierbei sind einander entsprechende Komponenten mit den gleichen Bezugszeichen wie in den Fig. 1 und 2 bezeichnet, zu ihrer Unterscheidung jedoch mit einem ergänzenden Buchstaben versehen. Ferner wird hierbei auf die gesamte vorangehende Beschreibung Bezug genommen.

In Fig. 3 ist eine weitere Ausführungsform der Erfindung dargestellt, welche der vorangehend beschriebenen Ausführungsform im wesentlichen entspricht und im Unterschied hierzu lediglich eine andere Konfiguration des Katodenmaterialkörpers aufweist, der gemäß Fig. 3 ebenfalls als Messingzylinder 21 ausgebildet ist, jedoch um eine Drehachse 23a drehbar ist, die in Richtung hin zu einer Anodenanordnung 5a ausgebildet ist, so daß ein verdampfungsaktiver Teil 27a der Oberfläche des Messingzylinders 21a auf einer Stirnfläche des Zylinders 21a angeordnet ist. Bei Drehung des Messingzylinders 21a durch einen Motor 49a um die Drehachse 23a bestreicht der verdampfungsaktive Teil 27a eine Kreisringfläche auf dem Zylinderboden 71. Der verdampfungsaktive Teil 21 der Zylinderbodenfläche 71 wird hierbei definiert durch eine Blendenöffnung 45a einer den übrigen Teil der Zylinderbodenfläche abschattenden Blendenanordnung 43a.

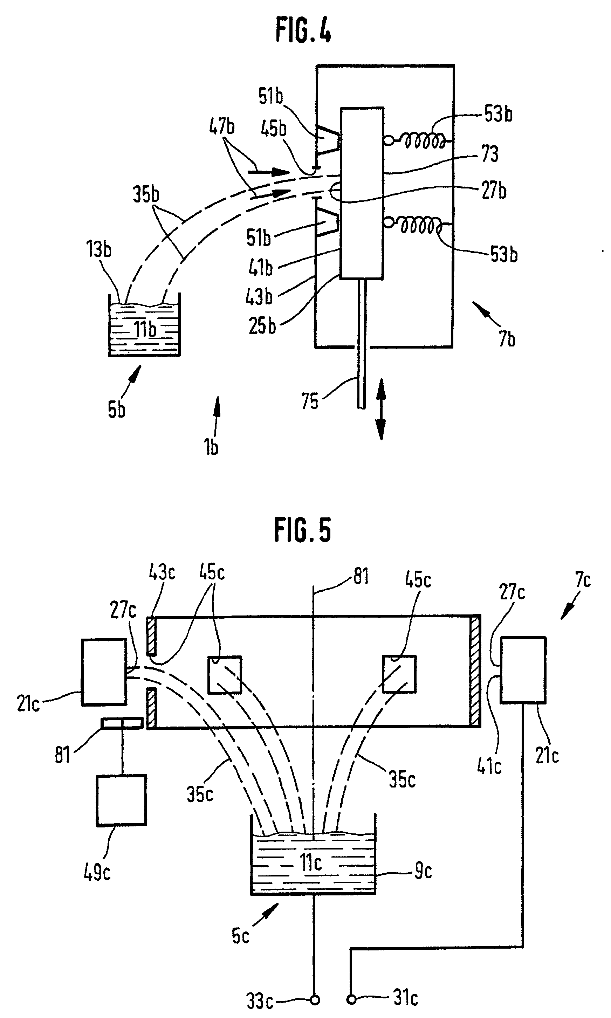

Bei der in Fig. 4 dargestellten Elektrodenanordnung 1b ist der Messingkörper als sich längs erstreckender Stab 21b ausgebildet, dessen auf eine Anodenanordnung 5 zuweisende Flachseite 25b im wesentlichen abgeschattet ist durch eine Blen-denanordnung 43b, in welcher eine Blendenöffnung 45b ausgenommen ist, um auf der Flachseite 25b einen verdampfungsaktiven Teil 27b zu begrenzen. An eine von der Flachseite 25b wegweisende Flachseite 73 des Messingstabs 21b greifen sich an der Blendenanordnung 43b abstützende Federn 53b an, welche den Stab 21b mit seiner Flachseite 25b in Richtung hin zu der Anodenanordnung 5 gegen Schleifklötze 51b drücken, welche an der Blendenanordnung 43b festgelegt sind. Der Messingstab 21b ist mit einem Antriebsstab 75 gekoppelt, der wiederum mit einem in der Fig. 4 nicht dargestellten Antrieb verbunden ist, um den Stab 21b zur Hinund Herbewegung anzutreiben. Durch die Hin- und Herbewegung wird der verdampfungsaktive Teil 27b der Flachseite 25b auf dieser ebenfalls hin und her bewegt, so daß nach und nach verschiedene Bereiche der Flachseite 25b als verdampfungsaktive Teile 27 wirken, wodurch die negative Wirkung von Abscheidungen von Partikeln 47b, welche aus der Siliciumschmelze 27b stammen, vermindert wird.

In Fig. 5 ist eine Elektrodenanordnung 1c mit einer Anodenanordnung 5c, welche ebenfalls eine Siliciumschmelze 11c umfaßt, und einer Kathodenanordnung 7c schematisch dargestellt. Die Kathodenanordnung 7c umfaßt hierbei einen bezüglich der Anodenanordnung 5c feststehenden Kathodenmaterialring 21c aus Messing, welcher zentral oberhalb der Siliciumschmelze 11c angeordnet ist. Radial innerhalb des Messingrings 21c ist eine Kreisringblende 43c angeordnet, welche über einen Motor 49c und eine Andruckrolle 81 zur Drehung um ihre Symmetrieachse 83 angetrieben ist. Die Ringblende 43c schattet einen großen Teil der Zylinderinnenmantelfläche 25c des Messingrings 21c ab, während eine Mehrzahl in Umfangsrichtung verteilt angeordneter Blendenöffnungen 45c in der Ringblende 43c verdampfungsaktive Teile 27c auf der Zylinderinnenfläche 25c des Messingrings 21c für eine Bogenentladung 35c exponiert, wobei alle übrigen Bereiche der Zylinderinnenmantelfläche 25c als verdampfungsinaktive Teile 41c gegenüber der Bogenentladung 35c abgeschattet sind. Durch die Drehung der Ringblende 43c um ihre Achse 81 bewegen sich die verdampfungsaktiven Teile 27c in Umfangsrichtung über die Zylinderinnenmantelfläche 25c des Messingrings 21c, so daß nach und nach die gesamte Innenmantelfläche 25c der reinigenden Wirkung durch die intensive Bogenentladung 35c ausgesetzt ist, um von der Siliciumschmelze 11c ausgehende Materialablagerungen auf derselben zu entfernen.

Bei den Ausführungsformen gemäß Fig. 1 und 2 sowie Fig. 4 wird die Reinigung der Kathodenmaterialfläche unterstützt durch die Wirkung von Schleifklötzen. Derartige Maßnahmen können auch bei den Ausführungsformen gemäß Fig. 3 und 5 vorgesehen sein. Hierbei können alternativ zu den Schleifklötzen, die abrasiv wirken, auch Abstreifeinrichtungen in Form von Bürsten oder spanabhebende Vorrichtungen, wie Drehmeißel oder Fräser, vorgesehen sein. Diese Rei-nigungsvorrichtungen können hierbei auch relativ zu der Blendenanordnung bewegt sein, wie etwa rotierende Bürsten oder Fräser. Ferner können die Reinigungsmittel auch andere physikalische Techniken, wie etwa Ionenbombardierung oder Ätzen usw., umfassen.

Um das Auftreffen der unerwünschten Partikel auf der Kathodenmaterialoberfläche und deren darauffolgendes Anhaften daran zu mindern, weist die Ausführungsform gemäß Fig. 1 und 2 eine Gaszuführungseinrichtung auf, welche einen Gasstrom aus der Blendenöffnung heraus erzeugt. Derartige Maßnahmen können auch an den Ausführungsfonnen gemäß Fig. 3 bis 5 getroffen sein.

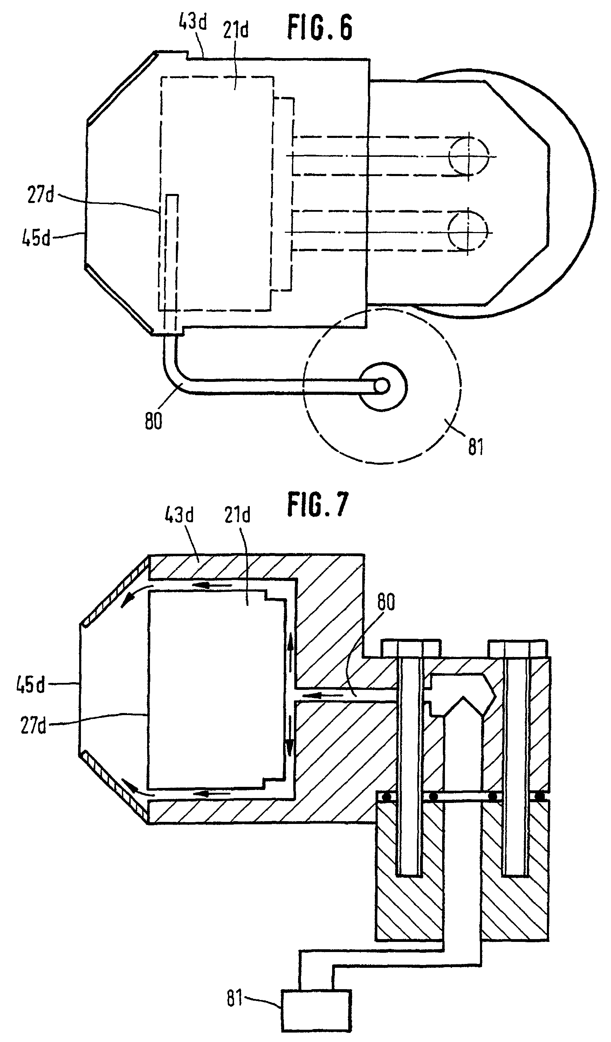

Bei den in den Fig. 6 und 7 dargestellten Ausführungsformen handelt es sich um feststehende Elektrodenanordnungen, bei denen sowohl die Blende wie auch die Kathode feststehend, also nicht rotierend oder für den Betriebsablauf translatorisch bewegbar ausgebildet ist. In der Ausführungsform nach Fig. 6 ist die Blende mit 43d bezeichnet, welche die nur strichliert dargestellte Kathode 21d haubenartig umgreift. Die Haube 43d weist an der Vorderseite eine Blendenöffnung 45d auf, welche den verdampfungsaktiven Teil 27c der Kathode 21d für die Bogenentladung freigibt. Die übrigen Teile der Elektrodenanordnung sind konventioneller Bauart, so dass eine weitere Darlegung der Konstruktion entbehrlich ist. Allerdings wird über eine Gaszuführleitung 80 inertes Schutzgas, insbesondere Sauerstoff, Argon oder ein Sauerstoff-Argon-Gasgemisch oder ein anderes geeignetes Gas-/Gasgemisch, auf den Bereich des verdampfungsaktiven Teils 27d der Kathode innerhalb der Haube 43d zugeführt und zwar von einer nur strichliert dargestellten Schutzgasquelle 81. Das damit direkt vor die Kathodenoberfläche eingelassene Schutzgas, welches hier im Bereich nahe der Blendenöffnung 45d eingelassen wird, tritt über die Blendenöffnung 45d zusammen mit den vom verdampfungsaktiven Teil 27d der Kathode abgedampften Partikeln über die Blendenöffnung 45d aus, so dass vor der Kathode ein eigenständiges und von der Si-Dampfwolke unabhängiges Plasma erzeugt und aufrecht erhalten werden kann. Durch das Entkoppeln von der Si-Dampfwolke kann die Bogenentladung und damit der Plasmaprozess erheblich stabiler und konstant über längere Prozesszeiten betrieben werden.

Dies ist besonders vorteilhaft für ein Nachchargieren der Verbrauchsmaterialien. Ohne die Schutzgaszuführung würde die vorhandene restliche Si-Dampfwolke im Zeitraum des Nachchargierens der Kathode die Kathodenoberfläche derart stark belegen, dass ein sicheres Wiederzünden und/oder Weiterbetrieb nicht mehr zufriedenstellend gewährleistet werden könnte.

Bei der Ausführungsform nach Fig. 7, in welcher die selben Bezugszeichen wie in Fig. 6 verwendet worden sind, erfolgt die Zufuhr des Schutzgases von der rückwärtigen Seite der Kathode 21d her, also von einer Seite abgewendet und gegenüberliegend von der Blendenöffnung 45d. Diese Ausführungsform hat den Vorteil, dass die Kathode vollständig vom Schutzgas überströmt und damit geschützt wird gegen Zutritt von Partikeln aus der Si-Dampfwolke. Dadurch wird wiederum sehr wirksam eine Vergiftung der Kathodenoberfläche durch verdampfte Si-Oxide verhindert und damit vermieden, dass die Oberfläche der Kathode hierdurch teilweise mit einer isolierenden Schicht bedeckt wird, was eine Zündung des Bogens verhindern würde, und langfristig auch die Ausnutzung der Kathode und die Betriebsdauer stark einschränken würde. Durch die Schutzgaszuführung wird ein Bereich höheren Partialdruckes vor der Kathodenoberfläche erzeugt, wobei das Schutzgas durch die Blendenöffnung zum Prozessraum ausströmt. Die verwendete Gasmenge pro Kathode liegt zwischen 5 sccm bis 50 sccm, vorzugsweise beträgt sie 10 sccm.

Die in den Fig. 6 und 7 dargestellte feststehende Elektrodenanordnung kann als eine Elektrodenanordnung seitlich versetzt oberhalb des Tiegels mit der Siliciumschmelze angeordnet werden. Es können jedoch auch mehrere Elektroden-anordnungen gegenüberliegend oder über den Umfang des Tiegels gruppiert angeordnet vorgesehen sein.

Neben der beschriebenen Beschichtung von Getränkeflaschen aus Kunststoff kann die Elektrodenanordnung für jegliche andere Art von Beschichtung eingesetzt sein. Insbesondere ist hierbei an die Beschichtung von Flachmaterial, insbesondere in Form von Bandmaterial, gedacht. Eine gleichmäßige Beschichtung größerer Flächen wird hierbei vorzugsweise dadurch erzielt, dass eine Mehrzahl von Elektrodenanordnungen in Reihen oder/und versetzt zueinander angeordnet ist.

Bei den vorangehend beschriebenen Ausführungsformen ist die abzuscheidende Materialschicht eine SiOₓ-Schicht, welche mit Metallatomen dotiert ist, die von der Messingkathode herausgelöst wurden. Die Erfindung ist jedoch nicht auf diese Materialien beschränkt, so dass jegliche andere Materialien zum Einsatz kommen können, wobei eine Hauptkomponente der Materialschicht durch anodische Verdampfung und eine Dotierungskomponente der Materialschicht durch Herauslösen aus einer Plasmaentladungskathode bereitgestellt sein können.

Es ist ebenfalls daran gedacht, eine Kühleinrichtung für den Kathodenmaterialkörper vorzusehen. Eine derartige Kühleinrichtung kann beispielsweise mittels wasserdurchflossener Rohre gebildet sein.

Neben den vorangehend beschriebenen Geometrien des Kathodenmaterialkörpers sind für diesen auch andere Geometrien denkbar, welche die Unterteilung der Kathodenmaterialoberfläche in einen verdampfungsaktiven und einen verdampfungsinaktiven Teil ermöglichen.

## Patentansprüche

1. Elektrodenanordnung zur plasmaunterstützten Beschichtung eines Substrats (3) mit einer wenigstens eine erste und eine zweite Materialkomponente umfassenden Materialschicht, wobei zur Erzeugung einer Plasmaentladung, insbesondere einer Bogenentladung (35), eine Anodenanordnung (5), welche die erste Materialkomponente an einer Anodenmaterialoberfläche (13) zur Verdampfung bereitstellt, und eine Kathodenanordnung (7), welche die zweite Materialkomponente an einer Katodenmaterialoberfläche (25) bereitstellt, vorgesehen sind, **dadurch gekennzeichnet, daß** die Kathodenmaterialoberfläche (25) aus einem die Plasmaentladung (35) stützenden verdampfungsaktiven Teil (27) und einem die Plasmaentladung nicht stützenden verdampfungsinaktiven Teil (41) gebildet ist, wobei eine Blendenanordnung vorgesehen ist, deren Blendenöffnung den verdampfungsaktiven Teil für die Plasmaentladung exponiert und welche den verdampfungsinaktiven Teil der Kathodenmaterialoberfläche gegenüber der Plasmaentladung abschattet.

2. Elektrodenanordnung nach Anspruch 1, **dadurch gekennzeichnet, daß** eine den verdampfungsaktiven Teil (27) und entsprechend den verdampfungsinaktiven Teil (41) über die Kathodenmaterialoberfläche (25) bewegende Bewegungserzeugungseinrichtung (49) vorgesehen ist, um aus der ersten Materialkomponente hervorgehende Materialabscheidungen auf der Kathodenmaterialoberfläche (25) zu reduzieren.

3. Elektrodenanordnung nach Anspruch 1 oder 2, **dadurch gekennzeichnet, daß** die Bewegungserzeugungsanordnung eine den verdampfungsaktiven Teil (27) an einer Blendenöffnung (45) für die Plasmaentladung (35) exponierende und den verdampfungsinaktiven Teil (41) entsprechend gegenüber der Plasmaentladung (35) abschattende Blendenanordnung (43) und einen die Blendenöffnung (45) relativ zu der Kathodenmaterialoberfläche (25) bewegenden Antrieb (49) umfaßt.

4. Elektrodenanordnung nach Anspruch 3, **dadurch gekennzeichnet, daß** die Blendenöffnung (45; 45a; 45c) bezüglich der Anodenanordnung (5; 5a; 5c) feststehend angeordnet ist.

5. Elektrodenanordnung nach Anspruch 3 oder 4, **dadurch gekennzeichnet, daß** die Kathodenmaterialoberfläche als Zylinderaußenmantelfläche (25) eines Kathodenmaterialkörpers (21) ausgebildet ist, welcher durch den Antrieb (49) um seine Zylinderachse (23) drehantreibbar ist.

6. Elektrodenanordnung nach Anspruch 3 oder 4, **dadurch gekennzeichnet, daß** die Kathodenmaterialoberfläche als Kreisringfläche (71) eines Kathodenmaterialkörpers (21a) ausgebildet ist, welcher durch den Antrieb (49a) um eine senkrecht zu der Kreisringfläche sich erstreckende Zentralachse (23a) drehantreibbar ist.

7. Elektrodenanordnung nach Anspruch 3 oder 4, **dadurch gekennzeichnet, daß** die Kathodenmaterialoberfläche als sich linear erstreckende Fläche (25b) eines Katodenmaterialkörpers (21b) ausgebildet ist, welcher durch den Antrieb in einer Erstreckungsrichtung der Fläche (25b) hin und her bewegbar ist.

8. Elektrodenanordnung nach einem der Ansprüche 1 bis 7, **dadurch gekennzeichnet, daß** die Blendenanordnung (43) die Kathodenmaterialoberfläche (25) zur Bildung der die Plasmaentladung (35) nicht stützenden verdampfungsinaktiven Teil (27) wenigstens teilweise haubenartig umgreift.

9. Elektrodenanordnung nach einem der Ansprüche 1 bis 8, **dadurch gekennzeichnet, daß** Schutzgas vor die Kathodenmaterialoberfläche, vorzugsweise dem verdampfungsaktiven Teil (27, 27a - d) der Kathodenmaterialoberfläche über eine Gaszuführungseinrichtung zugeführt wird.

10. Elektrodenanordnung nach Anspruch 9, **dadurch gekennzeichnet, daß** das Schutzgas in einen Zwischenraum (63) zwischen der Blendenanordnung (43) und der Kathodenmaterialoberfläche (25) derart vorgesehen ist, dass das zugeführte Schutzgas wenigstens teilweise durch die Blendenöffnung hin zu der Plasmaentladung aus dem Zwischenraum zwischen Kathodenmaterialoberfläche und Blendenanordnung (43, 43a - 43d) entweicht.

11. Elektrodenanordnung nach Anspruch 10, **dadurch gekennzeichnet, daß** das Schutzgas auf der der Blendenöffnung (27, 27a - 27d) abgewandten rückwärtigen Seite der Kathodenmaterialoberfläche zugeführt wird.

12. Elektrodenanordnung nach einem der Ansprüche 1 bis 11, **dadurch gekennzeichnet, daß** die Kathodenmaterialoberfläche als konvexe Oberfläche (25) eines Kathodenmaterialkörpers (21) ausgebildet ist, so dass die verdampfunsgsaktive Fläche (27) an einem zu der Anodenmaterialoberfläche (13) hinweisenden Bereich der Oberfläche (25) ausgebildet ist, und dass durch den Antrieb (49) die Orientierung des Kathodenmaterialkörpers (21) bezüglich der Anodenmaterialoberfläche (13) änderbar ist.

13. Elektrodenanordnung nach einem der Ansprüche 1 bis 12, **dadurch gekennzeichnet, daß** Reinigungsmittel (51; 51b) vorgesehen sind, um die Materialabscheidungen im Bereich des verdampfungsinaktiven Teils (41) der Kathodenmaterialoberfläche (25; 25b) zu entfernen.

14. Elektrodenanordnung nach Anspruch 13, **dadurch gekennzeichnet, daß** die Reinigungsmittel eine Abstreifvorrichtung, insbesondere eine Bürste, oder/und eine die Kathodenmaterialoberfläche abrasiv bearbeitende Vorrichtung (51; 51b) oder/und eine die Kathodenmaterialoberfläche spanabhebend bearbeitende Vorrichtung umfaßt.

15. Elektrodenanordnung nach einem der Ansprüche 1 bis 14, **dadurch gekennzeichnet, daß** eine Nachführvorrichtung (29, 61; 53b, 51b) vorgesehen ist, welche einen Abstand zwischen der Anodenmaterialoberfläche (13; 13b) und dem verdampfungsaktiven Teil (27; 27b) der Kathodenmaterialoberfläche (25; 25b) im wesentlichen konstant hält.

16. Elektrodenanordnung nach einem der Ansprüche 1 bis 15, **dadurch gekennzeichnet, daß** die Kathodenanordnung (7c) eine Mehrzahl von mit räumlichem Abstand voneinander angeordneten verdampfungsaktiven Teilen (27c) der Katodenmaterialoberfläche (25c) umfaßt.

17. Elektrodenanordnung nach einem der Ansprüche 1 bis 16, **dadurch gekennzeichnet, daß** die Anodenanordnung (5) einen heizbaren Schmelztiegel (9) zur Verflüssigung der ersten Materialkomponente (11) umfaßt.

18. Elektrodenanordnung nach einem der Ansprüche 1 bis 17, **dadurch gekennzeichnet, daß** die erste Materialkomponente Silicium und die zweite Materialkomponente Kupfer oder/und Zink oder Messing oder/und Magnesium umfaßt.

19. Verwendung der Elektrodenanordnung nach einem der Ansprüche 1 bis 18 zur Beschichtung von Verpackungsmaterial, insbesondere aus PET und insbesondere in Form einer Getränkeflasche (3) mit einer diffusionsdämmenden oder/und permeationsdämmenden Materialschicht.

20. Verwendung der Elektrodenanordnung nach einem der Ansprüche 1 bis 18 zur Beschichtung von Bandmaterial, insbesondere in Form eines Folienbands.

## Claims

1. An electrode assembly for plasma-assisted coating of a substrate (3) with a layer of material including at least a first and a second material component, whereby, in order to produce a plasma discharge, particularly an arc discharge (35), an anode arrangement (5), which provides the first material component on an anode material surface (13) for vaporisation, and a cathode arrangement (7), which provides the second material component on a cathode material surface (25), are provided, **characterised in that** the cathode material surface (25) is constituted by a vaporisation-active portion (27), which assists the plasma discharge (35), and a vaporisation-inactive portion (41), which does not assist the plasma discharge, an orifice assembly being provided, the orifice opening of which exposes the vaporisation-active portion for the plasma discharge and which shields the vaporisation-inactive portion of the cathode material surface with respect to the plasma discharge.

2. An electrode assembly as claimed in Claim 1, **characterised in that** a movement producing device (49) is provided, which moves the vaporisation-active portion (27) and, correspondingly, the vaporisation-inactive portion (41) over the cathode material surface (25) in order to reduce material deposits on the cathode material surface (25) coming from the first material component.

3. An electrode assembly as claimed in Claim 1 or 2, **characterised in that** the movement producing device includes an orifice assembly (43), which exposes the vaporisation-active portion (27) at an orifice opening (45) for the plasma discharge (35) and shields the vaporisation-inactive portion (41) correspondingly with respect to the plasma discharge (35), and an actuator (49), which moves the orifice opening (45) relative to the cathode material surface (25).

4. An electrode assembly as claimed in Claim 3, **characterised in that** the orifice opening (45; 45a; 45c) is fixedly arranged with respect to the anode arrangement (5; 5a; 5c).

5. An electrode assembly as claimed in Claim 3 or 4, **characterised in that** the cathode material surface is formed as the outer cylindrical wall surface (25) of a cathode material body (21), which is rotatable about its cylinder axis (23) by the actuator (49).

6. An electrode assembly as claimed in Claim 3 or 4, **characterised in that** the cathode material surface is formed as a circular annular surface (71) of a cathode material body (21a), which is rotatable by the actuator (49a) about a central axis (23a) extending perpendicular to the circular annular surface.

7. An electrode assembly as claimed in Claim 3 or 4, **characterised in that** the cathode material surface is formed as a linear extending surface (25b) of a cathode material body (21b), which may be moved back and forth by the actuator in an extension direction of the surface (25b).

8. An electrode assembly as claimed in one of Claims 1 to 7, **characterised in that** the orifice assembly (43) engages at least partially in the manner of a shroud around the cathode material surface (25) to constitute the vaporisation-inactive portion (27), which does not assist the plasma discharge (35).

9. An electrode assembly as claimed in one of Claims 1 to 8, **characterised in that** inert gas is supplied in front of the cathode material surface, preferably the vaporisation-active portion (27, 27a-d) of the cathode material surface via a gas supply device.

10. An electrode assembly as claimed in Claim 9, **characterised in that** the inert gas is provided in a space (63) between the orifice assembly (43) and the cathode material surface (25) such that the supplied inert gas escapes at least partially through the orifice opening towards the plasma discharge out of the space between the cathode material surface and the orifice assembly (43, 43a-43d).

11. An electrode assembly as claimed in Claim 10, **characterised in that** the inert gas is supplied on the rear side of the cathode material surface remote from the orifice opening (27, 27a-27d).

12. An electrode assembly as claimed in one of Claims 1 to 11, **characterised in that** the cathode material surface is constructed in the form of a convex surface (25) of a cathode material body (21) so that the vaporisation-active surface (27) is formed on a region of the surface (25) directed towards the anode material surface (13) and that the orientation of the cathode material body (21) with respect to the anode material surface (13) may be altered by the actuator (49).

13. An electrode assembly as claimed in one of Claims 1 to 12, **characterised in that** cleaning means (51; 51b) are provided in order to remove the material deposits in the region of the vaporisation-inactive portion (41) of the cathode material surface (25; 25b).

14. An electrode assembly as claimed in Claim 13, **characterised in that** the cleaning means includes a stripping device, particularly a brush and/or a device (51; 51b), which acts abrasively on the cathode material surface and/or a device which machines the cathode material surface in a manner which removes material.

15. An electrode assembly as claimed in one of Claims 1 to 14, **characterised in that** a tracking device (29, 61; 53b, 51b) is provided, which maintains a distance between the anode material surface (13; 13b) and the vaporisation-active portion (27; 27b) of the cathode material surface (25; 25b) substantially constant.

16. An electrode assembly as claimed in one of Claims 1 to 15, **characterised in that** the cathode arrangement (7c) includes a plurality of vaporisation-active portions (27c) of the cathode material surface, which are arranged spaced from one another.

17. An electrode assembly as claimed in one of Claims 1 to 16, **characterised in that** the anode arrangement (5) includes a heatable melting crucible (9) for liquefying the first material component (11).

18. An electrode assembly as claimed in one of Claims 1 to 17, **characterised in that** the first material component includes silicon and the second material component includes copper and/or zinc and/or brass and/or magnesium.

19. Use of the electrode assembly as claimed in one of Claims 1 to 18 for coating packaging material, particularly of PET and particularly in the form of a beverage bottle (3) with a diffusion-preventing and/or permeation-preventing layer of material.

20. Use of the electrode assembly as claimed in one of Claims 1 to 18 for coating strip material, particularly in the form of a film strip.

## Revendications

1. Dispositif d'électrode destiné au revêtement, assisté par plasma, d'un substrat (3) avec une couche de matière comprenant au moins un premier et un deuxième composant de matière, où l'on prévoit, en vue de générer une décharge de plasma, en particulier une décharge en arc (35), un dispositif d'anode (5) qui fournit, sur une surface de matière de l'anode (13), le premier composant de matière pour la vaporisation, et un dispositif de cathode (7) qui fournit, sur une surface de matière de la cathode (25), le deuxième composant de matière, **caractérisé en ce que** la surface de matière de la cathode (25) est formée d'une partie active quant à la vaporisation (27) qui assiste la décharge de plasma (35), et d'une partie inactive quant à la vaporisation (41) qui n'assiste pas la décharge de plasma, où l'on prévoit un dispositif de diaphragme dont l'ouverture expose la partie active quant à la vaporisation pour la décharge de plasma, et qui masque la partie de la surface de matière de la cathode qui est inactive quant à la vaporisation à l'égard de la décharge de plasma.

2. Dispositif d'électrode selon la revendication 1, **caractérisé en ce que** l'on prévoit un dispositif permettant la génération d'un mouvement (49) destiné à déplacer la partie active quant à la vaporisation (27) et, de manière correspondante, la partie inactive quant à la vaporisation (41), au-dessus de la surface de matière de la cathode (25), afin de limiter les dépôts de matière, provenant du premier composant de matière, sur la surface de matière de la cathode (25).

3. Dispositif d'électrode selon la revendication 1 ou 2, **caractérisé en ce que** le dispositif permettant la génération d'un mouvement comprend un dispositif de diaphragme (43) qui expose, au niveau d'une ouverture de diaphragme (45), la partie active quant à la vaporisation (27) pour la décharge de plasma (35), et qui, de manière correspondante, masque la partie inactive quant à la vaporisation (41) à l'égard de la décharge de plasma (35), ainsi qu'un dispositif d'entraînement (49) qui déplace l'ouverture de diaphragme (45) par rapport à la surface de matière de la cathode (25).

4. Dispositif d'électrode selon la revendication 3, **caractérisé en ce que** l'ouverture de diaphragme (45 ; 45a ; 45c) est disposée de manière fixe par rapport au dispositif d'anode (5 ; 5a ; 5c).

5. Dispositif d'électrode selon la revendication 3 ou 4, **caractérisé en ce que** la surface de matière de la cathode est réalisée sous la forme d'une surface de chemise extérieure d'un cylindre (25) d'un corps de matière de la cathode (21), corps qui peut être soumis à un entraînement rotatif autour de son axe de cylindre (23) au moyen du dispositif d'entraînement (49).

6. Dispositif d'électrode selon la revendication 3 ou 4, **caractérisé en ce que** la surface de matière de la cathode est réalisée sous la forme d'une surface en couronne circulaire (71) d'un corps de matière de la cathode (21a), corps qui peut être soumis à un entraînement rotatif autour d'un axe central (23a) s'étendant perpendiculairement à la surface en couronne circulaire au moyen du dispositif d'entraînement (49a).

7. Dispositif d'électrode selon la revendication 3 ou 4, **caractérisé en ce que** la surface de matière de la cathode est réalisée sous la forme d'une surface (25b), s'étendant de manière linéaire, d'un corps de matière de la cathode (21b), corps que l'on peut déplacer, au moyen du dispositif d'entraînement, selon un mouvement de va et vient dans une direction de l'extension de la surface (25b) .

8. Dispositif d'électrode selon l'une quelconque des revendications 1 à 7, **caractérisé en ce que** le dispositif de diaphragme (43) recouvre, au moins partiellement de manière à former une coiffe, la surface de matière de la cathode (25), afin de former la partie inactive quant à la vaporisation (27) qui n'assiste pas la décharge de plasma (35).

9. Dispositif d'électrode selon l'une quelconque des revendications 1 à 8, **caractérisé en ce que** l'on introduit, par l'intermédiaire d'un dispositif d'alimentation en gaz, un gaz protecteur à l'avant de la surface de matière de la cathode, de préférence à l'avant de la partie active quant à la vaporisation (27, 27a à 27d) de la surface de matière de la cathode.

10. Dispositif d'électrode selon la revendication 9, **caractérisé en ce que** l'on prévoit l'alimentation en gaz protecteur dans un espace intermédiaire (63) situé entre le dispositif de diaphragme (43) et la surface de matière de la cathode (25), de sorte que le gaz protecteur introduit s'échappe, au moins partiellement, de l'espace intermédiaire situé entre la surface de matière de la cathode et le dispositif de diaphragme (43, 43a à 43d), en passant par l'ouverture de diaphragme en direction de la décharge de plasma.

11. Dispositif d'électrode selon la revendication 10, **caractérisé en ce que** l'on introduit le gaz protecteur par le côté arrière de la surface de matière de la cathode, côté qui est opposé à l'ouverture de diaphragme (27, 27a à 27d).

12. Dispositif d'électrode selon l'une quelconque des revendications 1 à 11, **caractérisé en ce que** la surface de matière de la cathode est réalisée sous forme de surface (25) convexe d'un corps de matière de la cathode (21), de sorte que la surface active quant à la vaporisation (27) est formée dans une zone de la surface (25) qui est orientée vers la surface de matière de l'anode (13), et **en ce que** l'on peut modifier, au moyen du dispositif d'entraînement (49), l'orientation du corps de matière de la cathode (21) par rapport à la surface de matière de l'anode (13).

13. Dispositif d'électrode selon l'une quelconque des revendications 1 à 12, **caractérisé en ce que** l'on prévoit des moyens de nettoyage (51 ; 51b) afin d'éliminer les dépôts de matière dans la zone de la partie active quant à la vaporisation (41) de la surface de matière de la cathode (25 ; 25b).

14. Dispositif d'électrode selon la revendication 13, **caractérisé en ce que** les moyens de nettoyage comprennent un dispositif de raclage, en particulier une brosse, et/ou un dispositif (51 ; 51b) qui traite, par abrasion, la surface de matière de la cathode et/ou un dispositif qui traite, par enlèvement des copeaux, la surface de matière de la cathode.

15. Dispositif d'électrode selon l'une quelconque des revendications 1 à 14, **caractérisé en ce que** l'on prévoit un dispositif suiveur (29, 61 ; 53b, 51b) qui maintient un espacement essentiellement constant entre la surface de matière de l'anode (13 ; 13b) et la partie active quant à la vaporisation (27 ; 27b) de la surface de matière de la cathode (25 ; 25b).

16. Dispositif d'électrode selon l'une quelconque des revendications 1 à 15, **caractérisé en ce que** le dispositif de cathode (7c) comprend une pluralité de parties actives quant à la vaporisation (27c) de la surface de matière de la cathode (25c) disposées de manière espacée les unes par rapport aux autres.

17. Dispositif d'électrode selon l'une quelconque des revendications 1 à 16, **caractérisé en ce que** le dispositif d'anode (5) comprend un creuset (9) chauffable destiné à la liquéfaction du premier composant de matière (11).

18. Dispositif d'électrode selon l'une quelconque des revendications 1 à 17, **caractérisé en ce que** le premier composant de matière comprend du silicium et le deuxième composant de matière comprend du cuivre et/ou du zinc ou du laiton ou/et du magnésium.

19. Mise en oeuvre du dispositif d'électrode selon l'une quelconque des revendications 1 à 18 pour le revêtement de matériaux d'emballage, en particulier de matériaux d'emballage composés de PET et en particulier sous la forme d'une bouteille pour boissons (3), avec une couche de matière empêchant la diffusion et/ou empêchant la perméation.

20. Mise en oeuvre du dispositif d'électrode selon l'une quelconque des revendications 1 à 18 pour le revêtement de feuillard, en particulier sous la forme d'un ruban de film.
